(19) Europäisches Patentamt
European Patent Office
Office européen des brevets

(11) EP 4 276 482 B1

(12) **EUROPEAN PATENT SPECIFICATION**

(45) Date of publication and mention of the grant of the patent:
**20.08.2025 Bulletin 2025/34**

(21) Application number: **22305711.8**

(22) Date of filing: **13.05.2022**

(51) International Patent Classification (IPC):
***G01R 31/28*** *(2006.01)*

(52) Cooperative Patent Classification (CPC):
**G01R 31/2813; G01R 31/2812; G01R 31/2817**

(54) **CONDITION MONITORING OF PARALLEL POWER ELECTRONICS ELEMENTS**

ZUSTANDSÜBERWACHUNG VON PARALLELEN LEISTUNGSELEKTRONIKELEMENTEN

SURVEILLANCE DE L'ÉTAT D'ÉLÉMENTS D'ÉLECTRONIQUE DE PUISSANCE PARALLÈLES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.11.2023 Bulletin 2023/46**

(73) Proprietors:
- **Mitsubishi Electric R&D Centre Europe B.V.**
**1119 NS Schiphol Rijk Amsterdam (NL)**
Designated Contracting States:
**FR**
- **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**

(72) Inventors:
- **BRANDELERO, Julio**
**35708 RENNES CEDEX 7 (FR)**
- **DEGRENNE, Nicolas**
**35708 RENNES CEDEX 7 (FR)**
- **FOUBE, Laurent**
**35708 RENNES CEDEX 7 (FR)**

(74) Representative: **Plasseraud IP**
**104 Rue de Richelieu**
**CS92104**
**75080 Paris Cedex 02 (FR)**

(56) References cited:
**EP-A1- 3 121 612** **EP-A1- 3 492 935**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 276 482 B1

## Description

### Technical Field

This disclosure pertains to the field of power electronic modules. More specifically, the invention is related to the monitoring of assembly containing a plurality of devices/elements in parallel.

### Background Art

Such power devices are submitted to high thermic changes and high thermo-mechanical stresses. Due to the wide variety in the compositions and structures of the different parts/devices constituting the assembly, crack propagation, wire-bonds lift-off, delamination, metallization reconstruction and other effects lead to failure of the interconnections. Failure mechanisms are coupled and most often result in the lift-off of wire bonds. Such failures are very difficult to predict or to detect before the general breakdown of the assembly. In addition, the ageing of parallel devices may not be uniform due to e.g. manufacturing or mounting mismatches, resulting in electro-thermo-lifetime mismatches. Knowing the state of health of each power device in an assembly is important in the operating and maintenance phases to perform respectively lifetime extension and selective maintenance/replacement.

Monitoring the wire-bonds on-line can be performed using the steady-state voltage (referenced $V_{ce}$) through the device at high current and to compare it to a limit. To make the $V_{ce}$ specific to a single power device, the other parallel devices can be turned-off. Operating the devices one by one is possible to assess the individual degradation. However, this method requires individual drivers. The steady-state $V_{ce}$ is temperature and current (including ripple) dependent and calibration/corrections must be performed. In addition, clamp circuit must be implemented to protect the measure, imposing time-responses incompatible with fast switching frequencies and/or extreme duty-cycles. Finally, the connection to the high voltage imposes high design and safety constraints making this solution difficult to adopt. EP 3 121 612 deals with related topics and provides a method to predict failure of power semiconductor modules.

### Summary

This disclosure improves the situation.

It is proposed a method according to claim 1.

In another aspect, it is proposed a power electronic module according to claim 11.

In another aspect, it is proposed a computer software comprising instructions to implement a method as defined here when the software is executed by a processor. In another aspect, it is proposed a computer-readable non-transient recording medium on which a software is registered to implement the method as defined here when the software is executed by a processor.

The following features, can be optionally implemented, separately or in combination one with the others:

The extracted data include at least:

- the signs of local extremums of a sequence of two emitter voltages $V_{eE1}$ and $V_{eE2}$ of two elements, or
- the sign and the amplitude of local extremums of a sequence of emitter voltage $V_{eE}$ of one element; and, if a presence of a mismatch between said elements has been deduced, the method further comprising:
  e. deduce from the extracted data if an element of which the emitter voltage $V_{eE}$, or $V_{eE1}$ and $V_{eE2}$, has been measured is, or is not, the most degraded.

The extraction from the measurements is made by an analogic and logical circuit, such that the use of an Analog to Digital Converter is made redundant.

The extracted data further includes amplitudes of local extremums of said emitter voltage $V_{eE}$ during the measuring period

and, if a presence of a mismatch between said elements has been deduced, the method further comprising:

f. deduce from the extracted data a quantification of said mismatch.

A differential emitter voltage $V_{ee}$ of a pair of elements is measured.

Implemented on a module comprising at least three parallel power electronic elements, the measurements are made in a sequenced manner for each pair of elements with a common monitoring circuit, a multiplexer being operationally interfaced between said monitoring circuit and said elements.

The method further comprises:

- imposing a supplementary external gate resistance during the measuring operation.

The deduction operation further comprises to identify a most degraded element among at least two elements, and then

the series of operations is reiterated at least one time, the at least one reiteration including to induce a delay d of the turn-off of at least one of the elements with respect to another element before triggering the measuring period.

The series of operations is reiterated at least one time such that the detection mismatch is implemented along the operational life of the module.

The method further comprises:

- generating an alert signal in function of the deduced information.

## Brief Description of Drawings

Other features, details and advantages will be shown in the following detailed description and on the figures, on which:

**Fig. 1**
[Fig. 1] is a sectional side view of an assembly, or module, including two parallel semiconductor devices/elements.

**Fig. 2**
[Fig. 2] is a top view of an assembly according to [Fig. 1], where "Y" is the cutting plane of [Fig. 1].

**Fig. 3**
[Fig. 3] is a graphic showing the turn-off delay in function of the current flowing through a power element according to an embodiment.

**Fig. 4**
[Fig. 4] is a graphic showing the turn-off delay in function of the threshold voltage of a power element according to an embodiment.

**Fig. 5**
[Fig. 5] is a graphic showing the current flowing through two parallel power elements during a turn-off period according to an embodiment.

**Fig. 6**
[Fig. 6] shows an architecture of a power module according to an embodiment.

**Fig. 7**
[Fig. 7] shows an architecture of a power module according to an embodiment.

**Fig. 8**
[Fig. 8] is a graphic showing the waveforms of the emitter voltages of two parallel power elements of a module during a turn-off period according to an embodiment.

**Fig. 9**
[Fig. 9] is a graphic showing the superimposition of waveforms of an emitter voltage of a power element during turn-off periods according to an embodiment.

**Fig. 10**
[Fig. 10] is a graphic showing the superimposition of waveforms of an emitter voltage of a power element parallel to the power element of [Fig. 9] during the same turn-off periods according to an embodiment.

**Fig. 11**
[Fig. 11] shows schematically how to identify degraded power elements with a circuit according to an embodiment.

**Fig. 12**
[Fig. 12] is a graphic showing a maximum of emitter voltages ("peaks") of a power element in function of its degradation counted as a number n of wires lift-off.

**Fig. 13**
[Fig. 13] is a graphic showing the superimposition of waveforms of the voltage between the emitters of two parallel power elements of a module according to an architecture of [Fig. 6].

**Fig. 14**

[Fig. 14] is a graphic showing the superimposition of waveforms of the voltage between the emitters of two parallel power elements of a module according to an architecture of [Fig. 7].

**Fig. 15**

[Fig. 15] is a graphic showing a minimum of the voltage between the emitters of two parallel power elements of a module according to an architecture of [Fig. 6] according to an embodiment.

**Fig. 16**

[Fig. 16] is a graphic showing a minimum of the voltage between the emitters of two parallel power elements of a module according to an architecture of [Fig. 8] according to an embodiment.

**Fig. 17**

[Fig. 17] is a graphic showing a maximum of the voltage between the emitters of two parallel power elements of a module according to an architecture of [Fig. 6] according to an embodiment.

**Fig. 18**

[Fig. 18] is a graphic showing a maximum of the voltage between the emitters of two parallel power elements of a module according to an architecture of [Fig. 7] according to an embodiment.

**Fig. 19**

[Fig. 19] is a circuitry to impose a supplementary external resistance during a turn-off switching period according to an embodiment.

**Fig. 20**

[Fig. 20] is a logical diagram showing how to convert voltages offsets into delays offsets according to an embodiment.

**Fig. 21**

[Fig. 21] is a graphic showing how indexes about degradations of two parallel elements of a module can be constructed in function of the time according to an embodiment.

**Description of Embodiments**

It is now referred to [Fig. 1] and [Fig. 2]. In the following, an assembly, or a module 1, comprises at least two parallel power electronics elements 11. A power electronic element 11 can be, for example, a power semiconductor device, a power sub-module or a power converter. Here, the words "element" or "device" are used to designate sub-part of a power "module" or power "assembly" that are electrically connected in parallel one with respect to the other. The elements 11 of the same module 1 can be packaged together or separately one from the other.

[Fig. 1] is an example of a cutting view along the line referenced "Y" of the module 1 shown on [Fig. 2]. In a various embodiment, a top side view can show elements packaged separately. The element referenced "Z" on [Fig. 2] schematically represents an electrical isolation of a configuration wherein the elements 11.1 and 11.2 are disconnected one from the other as it will be explained hereinafter with reference to [Fig. 7]. The emitter pads (e1 and e2) of respectively elements 11.1 and 11.2 are separated one from the other. The Gate drivers (G1 and G2) of respectively elements 11.1 and 11.2 are separated one from the other. On the contrary, in a configuration wherein the elements 11.1 and 11.2 are connected one to the other as it will be explained hereinafter with reference to [Fig. 6] (common emitter pad E and common gate driver G), the isolation Z of [Fig. 2] would be absent. By simplicity, the external connections to the system are not drawn. On another configuration, elements 11.1 and 11.2 are based in separate mechanical structures described in [Fig. 1] with external electrical connection of the elements E, gate drivers (G1 and G2) and emitter pads (e1 and e2). In other words, the connection of the elements can be decided and made on the system level outside the device structure.

[Fig. 1] and [Fig. 2] show an example of a module 1 including two elements 11 (distinctly referenced 11.1 and 11.2 on [Fig. 2]), and comprising a superposition of layers. From the bottom to the top, the [Fig. 1] comprises of the elements 11: an electrical insulator layer 101 (for example based on aluminum oxide) and a conductive layer 102 (for example in copper). The module 1 further comprises parts that are associated separately to each element 11, from the bottom to the top: a solder layer 103, a semiconductor die 104 and a metallization layer 105. The module 1 further comprises conductive wire bonds 2 ensuring electrical connection between a part of the conductive layer 102 and the metallization layer 105 of the element 11 of the cutting view (the module 1 comprising at least two parallel power electronics elements 11).

Each element 11 comprises, here, a semiconductor die 104 which is a semiconductor element, for example, an Insulated Gate Bipolar Transistor (IGBT) or a Metal-Oxide-Semiconductor Field-Effect Transistor (MOSFET). It can be made of silicon, silicon carbide (SiC) and/or gallium nitride (GaN). The element 11 is a power electronic device: it is arranged to operate under a voltage superior to 50V and a current superior to 1A.

The semiconductor die 104 is metalized at least on one of its sides, here on its top side. In other words, the semiconductor die 104 is coated with a metallization 105. The metallization layer is, for example, made of an aluminum alloy. Such a metallization 105 has a thickness comprised between 1 and 20 micrometers. The free surface is used to fix wire bonds 2, for example by thermosonic bonding. Such a connection is subjected to hard conditions during operational life of the module 1 and some cracks and defects can appear at this specific location.

**Theory**

In a module 1 comprising at least two parallel power electronics elements 11, the load current is distributed through the various paralleled elements 11 according to their on-state resistance that is dependent on the assembly and the junction temperature. When a lift-off of the wire bonds 2 occurs, or any other electrical connection defect, an increase of the on-state electrical resistance of the element appears. When one element 11 is more degraded than the other(s) paralleled power element(s) 11, a current reduction flowing through the one element can be observed of e.g. 1% to 20%. The current reduction is supported on the paralleled power element(s) that will conduct more current.

Furthermore, in case of thermal degradation (generally causing delamination) the temperature on the degraded power element 11 increases, causing a reduction of the threshold voltage up to 0.5V.

In the following, the elements 11 are IGBT devices, but any skilled person can translate the explanations based on such examples to other power electronic elements, like MOSFET or MISFET semiconductors for example.

The applicants noticed that the turn-off waveform is strongly dependent on the current flowing in the element 11. With a classical gate drive circuit imposing a voltage step from a positive voltage $V_{cc}$ to a negative voltage $V_{ee}$, the gate voltage $V_{ge}$ over the time t in the paralleled elements can be calculated according to the following equation [Math. 1]. The saturation collector current is dependent on the gate voltage $V_{ge}$ according to the following equation [Math. 2]. The turn-off delay $t_d$ of an element, for example a die 104, crossed by a current $I_{sw}$, can be calculated with the following equation [Math. 3] in function of the gate resistance $R_g$, the input capacitance $C_{ies}$, the transconductance gfe, and the threshold voltage $V_{th}$.

[Math. 1]

$$V_{ge} = (V_{cc} - V_{ee}) \cdot e^{\frac{-t}{R_g \cdot C_{ies}}}$$

[Math. 2]

$$I_C = gfe \cdot (V_{ge} - V_{th})$$

[Math. 3]

$$t_d = R_g \cdot C_{ies} \cdot log\left(\frac{V_{cc} - V_{ee}}{V_{th} - V_{ge} + \frac{I_{sw}}{gfe}}\right)$$

[Fig. 3], respectively [Fig. 4], represents an example of the evolution of the turn-off delay $t_d$, in function of the turn-off current $I_{toff}$ (from which the current $I_{sw}$ is here subtracted to have a reference to zero), respectively in function of the threshold voltage $V_{th}$. The values shown on [Fig. 3] and [Fig. 4] are obtained for an element 11 which is, in the example, an IGBT known by its reference "CM100RX-24S1" and having the following nominal properties: $V_{cc}$ = 15V ; $V_{ee}$ = -5V ; $R_g$ = 72Ω ; $C_{ies}$ = 21 nF ; $V_{th}$ = 6V and gfe = 43 A/V.

Therefore, the element(s) with higher current should start the turn-off current switching before than the (deteriorated) element with lower current. The turn-off of a degraded element crossed by a reduced current can be delayed of few nanoseconds to 100ns. Furthermore, the elements with a higher threshold voltage $V_{th}$ should start the turn-off current switching before than the (deteriorated) element with a lower threshold voltage $V_{th}$. The turn-off of a degraded element submitted to a reduced voltage $V_{th}$ can be delayed of few nanoseconds to 40ns.

The following [Table 1] is a summary of the effects of two types of degradation of an element 11, wherein $R_{on}$ is the resistance of the element 11 in the on-state, $I_c$ is the current flowing through the element 11, $T_j$ is the junction temperature and $V_{ce}$ is the steady-state voltage.

[Table 1]

| Wire bonding 2 | Solder layer 103 |
|---|---|
| $\uparrow R_{on} \rightarrow \downarrow I_c \rightarrow \uparrow t_d$ | $\uparrow T_j \rightarrow \uparrow V_{th} \rightarrow \uparrow t_d$ |
| | $\uparrow T_j \rightarrow \uparrow V_{ce} \rightarrow \downarrow I_c \rightarrow \uparrow t_d$ |

[Fig. 5] shows the evolution of the current $I_c$ flowing through two parallel elements 11.1 and 11.2 (here two IGBTs) of a module 1 at the turn-off commutation when the first element 11.1 is more degraded than the second element 11.2. As we can see, the turn-off of the degraded element 11.1 is delayed. It momentarily sees its current increasing since it is alone to hold a higher proportion of the total load current.

A method for detection of a mismatch between parallel power electronic elements 11 into a power electronic module 1 can comprise:

a. in response to the detection of a common turn-off of said elements 11, triggering a measuring period;
b. during the measuring period, measuring a sequence of emitter voltages $V_{eE}$ of at least one of said elements;
c. extract data, from the measurements, said data including the sign and/or the amplitude of local extremums of said emitter voltage $V_{eE}$ during the measuring period;
d. deduce from the extracted data at least an existence or an absence of a mismatch between said elements.

It is now referred to [Fig. 6] and [Fig. 7] as examples. [Fig. 6] corresponds to a configuration wherein two paralleled elements 11.1 and 11.2 (IGBTs) have a common gate driver, while [Fig. 7] corresponds to a configuration wherein two paralleled elements 11.1 and 11.2 (IGBTs) have each their own gate driver. The changes on the currents, respectively I1 and I2, flowing through an element, respectively 11.1 and 11.2, can be observed on corresponding voltages.

On [Fig. 6] and [Fig. 7], the gate driver resistance and Kelvin resistors are not represented. Based on these examples, in various embodiments, each element 11 can comprise a single die or a combination of dies. The elements 11 of the same module 1 can be packaged together or not. They can have a common gate driver configuration ([Fig. 6]) or each their own corresponding gate driver ([Fig. 7]). The number of parallel power elements 11 in the module 1 is at least two. In various embodiments, it can be three, four, up to ten or even twenty for example.

In the example of [Fig. 6] and [Fig. 7], the corresponding emitter voltage of the elements 11.1 and 11.2 are respectively $V_{eE1}$ and $V_{eE2}$, induced on the parasitic inductor, respectively $L_{eE1}$ and $L_{eE2}$, between an emitter pad on the power semiconductor element 11.1, respectively 11.2, to an external emitter pad of the module 1. Such an inductor $L_{eE}$ is created by the connection of the power semiconductor element 11 to rest of the power module 1. The emitter pad on the power semiconductor element 11 can be measured using, for example, a Kelvin emitter disposed on the power module 1. In other words, the changes of the $V_{eE1}$ and $V_{eE2}$ (the shape of curves) are a proportional and derivative image of the power semiconductor currents because of the R-L behavior. As a skilled person in the art would understand, the corresponding voltages $V_{eE1}$ and $V_{eE2}$ can be measured at other points of the circuitry depending on the structure and the component types of each module 1: the above-described architecture with two IGBTs and parasitic inductors $L_{eE1}$ and $L_{eE2}$ are only examples, but the solution disclosed here is not limited to such architecture.

In some embodiments, the turn-off event can be detected directly from the triggering signal sent by a controller of the module 1, or indirectly by detecting a first peak (an extremum) of an emitter voltage $V_{eE}$. To detect a peak, the measured emitter voltage $V_{eE}$ value can be compared to predetermined values. For example, a peak can be recognized if the emitter voltage $V_{eE}$ value goes out of a nominal range centered on 0V, like -1V;1V, or -2V;2V.

It is now referred to [Fig. 8]. The emitter voltages $V_{eE1}$ and $V_{eE2}$ of the elements 11.1 and 11.2 are measured (and stored) starting from an instant t corresponding to the common turn-off command signal of said elements 11.1 and 11.2. In other words, the measures are synchronized with the common turn-off triggering. The values shown on [Fig. 8] corresponds to the measures made on the structure shown on [Fig. 7] (two IGBTs with separate Gate driver configuration).

**Mismatch or not mismatch**

In some embodiments, if the aim is only to determine if there is, or not, a mismatch in the module 1 without needing to identify which element is the most degraded, to monitor the absolute value of a single emitter voltages $V_{eE}$ of a single element 11 is sufficient, even if the sign is unknown, for example by comparing the said absolute value to a threshold value. The amplitude of local extremums of one emitter voltage $V_{eE}$ during the measuring period enables to deduce an existence or an absence of a mismatch between the corresponding element 11 and another element 11 of the module 1. In some embodiments with the same aim (only to determine if there is, or not, a mismatch in the module 1 without needing to identify which element is the most degraded), to monitor the two signs of a pair of emitter voltages $V_{eE1}$ and $V_{eE2}$ of a pair of elements 11.1 and 11.2 is sufficient, even if the absolute value itself is unknown, for example by checking if the two signs are different. The signs of local extremums of two emitter voltages $V_{eE1}$ and $V_{eE2}$ during the measuring period enables to deduce an existence or an absence of a mismatch between the corresponding elements 11.1 and 11.2. These two possibilities (a single absolute value $V_{eE}$ compared to a threshold value, or two signs of two values $V_{eE1}$ and $V_{eE2}$ compared one to the other) is the reason why we can say that the needed data are the signs "and/or" the amplitude of local extremums of emitter voltages of "at least one element". Data comprising only one sign of a single value $V_{eE}$ should be avoided as it is less reliable to deduce the existence/absence of a mismatch.

**Most degraded, or not**

In some other embodiments, the aim is to determine if there is, or not, a mismatch in the module 1, and, if there is a mismatch, to also determine if the element 11 of which the emitter voltage $V_{eE}$ has been measured and extracted is or is not the most degraded, for example to plane a targeted intervention. The extremums (minimum and/or maximum) values of voltages $V_{eE1}$ and $V_{eE2}$ can be used to determine which element 11.1 or 11.2 conducts a large current as the switched current is inversely proportional to the minimum or the maximum value of the respective $V_{eE1}$ and $V_{eE2}$. In the example of [Fig. 8], $I_{C,11.1}$ = 89A and $I_{C,11.2}$ = 107A. On [Fig. 9] and [Fig. 10], the measured values for a plurality of test cases are superimposed: zero, one, two, three, four and five wire lift-off situations in one element 11. Each curve corresponds to one of the situations. [Fig. 9] shows the measured emitter voltage $V_{eE1}$ values of the element 11.1 while [Fig. 10] shows the measured emitter voltage $V_{eE2}$ values of the element 11.2. The following [Table 2] shows example of measured values (amplitude and sign) for amplitude (absolute value) above 0.5 V for both power elements 11.1 and 11.2 in the test case with five wire lift-offs.

[Table 2]

| Peak | Extremum of emitter voltage $V_{eE1}$ of the degraded Element 11.1 | Extremum of emitter voltage $V_{eE2}$ of the non-degraded Element 11.2 |
|---|---|---|
| ○ | +1 Volt | +1 Volt |
| I | + 3.65 Volts | - 2.8 Volts |
| II | - 5.4 Volts | + 1.8 Volts |
| III | | - 1.65 Volts |

As an example, the first value going outside a predetermined rang (for example [-0.5V ; +0.5V]) is designated as the triggering "peak", referenced "O" on the figures. The triggering peak can be used to define the temporal reference, trigger the measuring operation and synchronize them.

In the example, the first peak "I" after the reference peak "O", the extremum of emitter voltage $V_{eE1}$ of the element 11.1 is positive (+3.65V) while the extremum of emitter voltage $V_{eE2}$ of the element 11.2 is negative (-2.8V). Thus, it is possible to identify that element 11.1 is the most degraded among elements 11.1 and 11.2.

If a single emitter voltage $V_{eE}$ is measured and if it is possible to identify the first peak I corresponding to the turn-off triggering (for example in function of a command/triggering signal sent by a controller of the module 1), the sign of the emitter voltage $V_{eE}$ of the first peak I is sufficient to identify if the corresponding element is the most degraded or not: if the sign is positive, it is the most degraded element. If the sign is negative, it is not the most degraded element. This is true even for modules comprising more than two paralleled elements. To identify the first peak I to consider implies to avoid any confusion with a preliminary peak resulting directly from the turn-off command signal (corresponding to the peak "O" on [Fig. 9] and [Fig. 10]. An example to identify distinctly the preliminary peak O and the first peak I is to directly monitor the triggering/command signal sent by a controller of the module 1.

The values, and especially the signs, of the extremums are the key points of the measured values. To extract such data from the raw measurement signals can be made by using an Analog to Digital Converter (ADC). In some embodiment, the extraction of the extremums (identification of the "peaks") from the measurements is made by an analogic and logical circuit, such that the use of a costly Analog to Digital Converter is made redundant.

[Fig. 11] show examples of analogic and logical circuit that can be used. In the example described here, the analogic and logical circuit comprises a first signal conditioning circuit 201, a second signal conditioning circuit 202 and a module 203 including a RS flip flop and an inverter. In various embodiments, the analogic and logical circuit comprises other functionally equivalent portions.

The waveform A is an emitter voltage $V_{eE}$ measured on a most-degraded element 11. In practice, the status of relative degradation of each element 11 is unknown because it is one of the information that we want to determine. For example, if two power elements 11.1 and 11.2 are in parallel and 11.1 is more degraded, such a waveform is $V_{eE1}$ of the element 11.1 if the two emitters e1 and e2 of the power elements 11.1 and 11.2 are disconnected. When processed by the first signal conditioning circuit 201, respectively the second signal conditioning circuit 202, a logical signal A1, respectively A2, is outputted. When the pair of these two logical signals is analyzed, with the RS flip flop and an inverter (module 203), a logical signal is outputted (q=1) meaning the power element 11.1 is the most degraded.

The waveform B is an emitter voltage $V_{eE}$ measured on a not-most degraded element 11. For example, if two power elements 11.1 and 11.2 are in parallel and 11.2 is not the most degraded, such a waveform is $V_{e2e1} = V_{eE2}-V_{eE1}$ if the two emitters e1 and e2 of the power elements 11.1 and 11.2 are disconnected. When processed by the first signal conditioning circuit 201, respectively the second signal conditioning circuit 202, a logical signal B1, respectively B2, is outputted. When the pair of these two signals is analyzed, with the RS flip flop and the inverter (module 203), a logical signal is outputted (q=0) meaning the power element 11.2 is not the most degraded.

The waveform C is an emitter voltage $V_{eE}$ measured on a not-most degraded element 11. For example, if two power elements 11.1 and 11.2 are in parallel and 11.2 is not the most degraded, such a waveform is $V_{eE2}$ of the element 11.2 if the two emitters e1 and e2 of the power elements 11.1 and 11.2 are disconnected.

When processed by the first signal conditioning circuit 201, respectively the second signal conditioning circuit 202, a logical signal C1, respectively C2, is outputted. When the pair of these two signals is analyzed, with a RS flip flop and an inverter (module 203), a logical signal is outputted (q=0) meaning the power element 11.2 is not the most degraded.

To summarize, the output signal of the sequence analyzer 201, 202, 203 directly answers the logical question: "Is the monitored element the most degraded element?".

**Mismatch quantification**

In some embodiments, the degradation mismatch can be quantified. For example, assembly of a diode, a capacitor and a resistance, functioning as a peak detector, can be combined to the circuit shown on [Fig. 11]. A sampling by an ADC can be made, or the signal can be compared to a predetermined threshold value by a comparator, such that a quantification of the mismatch is obtained in function of the amplitude of extremum emitter voltage max($V_{eE}$). [Fig. 12] is an example of such quantification to determine a number of wire lift-offs.

**Kelvin to Kelvin voltage measurements**

In embodiments wherein a mismatch between only two elements 11 of a module 1 is monitored, a differential emitter voltage $V_{ee}$ can be obtained (measured) on the emitter pads of the elements 11.1 and 11.2. In other embodiments, two measures can be compared: $V_{e1e2} = V_{eE1} - V_{eE2}$. Doing this, only one sensor and conditioning circuit is needed (one by pair of elements 11), and the sensitivity to degradation mismatch is increased. In addition, some dependency on temperature and on current are reduced. Such an implementation is compatible with both architecture: common or separate gate driver configurations (examples of [Fig. 6] and [Fig. 7]).

[Fig. 13] shows the evolution of the emitter voltage $V_{e1e2}$ during a turn-off event, each curve corresponding to a specific number of wire lift-offs in the element 11.1, in a configuration of separated gate drivers. [Fig. 14] shows the evolution of the emitter voltage $V_{e1e2}$ during a turn-off event, each curve corresponding to a specific number of wire lift-offs in the element 11.1, in a configuration of common gate driver. [Fig. 15] shows the value of the negative extremum (minimum), a peak, in function of the degradation level unbalance quantified in number (n) of lift-offs, each curve corresponding to a specific situation of current I and temperature T, in a configuration of separated gate drivers. [Fig. 17] shows the same for positive extremum (maximum) of the emitter voltage $V_{e1e2}$. [Fig. 16] shows the same as [Fig. 15] in a configuration of common gate driver and [Fig. 18] shows the same as [Fig. 16] in a configuration of common gate driver.

In view of [Fig. 13] to [Fig. 18], the amplitude of the peaks is function of the degradation level. This is the case for both the common and separate gate driver configurations. In embodiments wherein the extracted data includes the amplitudes of local extremums of the measured emitter voltages $V_{eE}$ it is possible to deduce from the extracted data a quantification of a mismatch. When a sequence of emitter voltages $V_{eE1}$ and $V_{eE2}$ of a pair of elements 11.1 and 11.2 is measured by a Kelvin emitters sensor, it enables to obtain such information for modules 1 comprising such sensors.

To use only one single Kelvin emitters sensor for a pair of elements 11 is possible for both configurations: connected elements (like in [Fig. 6]) and disconnected elements (like in [Fig. 7]). In addition, it is very convenient because a Kelvin emitters sensor is available in some existing architecture: it is unnecessary to modify such existing architectures to add a Kelvin emitters sensor. And such sensor is cheap with respect to other existing sensors.

**Pair by pair monitoring**

In some embodiment, a multiplexer can be provided to connect a single monitoring circuit to the proper pair of elements 11 in order to advantageously limit the number of monitoring circuit to a single one even for a large number of power elements 11 in the module 1. The elements 11 are switched two by two, and for each pair, to monitor an emitter voltage $V_{e1e2}$.

### Enhanced sensitivity

In some embodiments, the method further comprises:

- imposing a supplementary external gate resistance during the measuring operation.

By artificially increasing the gate resistance for the measurements, the mismatch sensitivity is increased during the single switching time and the resulting increased losses are limited in time (only during the small period of measurements). [Fig. 19] shows an example of a circuit that can be used to impose temporarily such an increased resistance. A switch M3 is opened only during the measurement thank to the inverted trigger signal. During the measurements, the total gate resistance is the sum of $R_{gext}$ and $R_{gext2}$. Otherwise, the module 1 operates in a normal mode only with the external gate resistance $R_{gext}$.

### Feedback loop and Synchronization

In some embodiments, the method is executed a first time to identify a most degraded element, and then, the method is reiterated at least one time with a retrofit loop arranged to induce a delay of the turn-off of at least one of the elements with respect to the other(s) such that to converge toward a temporarily synchronized first peaks I.

Such embodiment with two elements 11.1 and 11.2 is represented on [Fig. 20]. The delay of the turn-off of the first element 11.1 is referenced $t_1$ and the delay of the turn-off of the second element 11.2 is referenced $t_2$. In embodiments with more than two elements, the same method can be used by applying the same delay t to the turn-off of the elements that are not identified as the "most degraded". The value of the induced delays $t_1$ and or $t_2$ can be adjusted step by step until a temporal synchronization of the first peaks I is reached. Doing this, by reducing the temporal offset and even before to reach a perfect synchronization, the turn-off losses are at least partially balanced in the module 1: the over-current in the module 1 is reduced and the resulting degradations consequences in the module 1 are reduced. The value of the absolute difference between the two imposed delays ($|t_1-t_2|$) can be used as an index of the relative degradation between the elements 11.1 and 11.2. For example, and as it is represented on [Fig. 20], value of the absolute difference between the two imposed delays ($|t_1-t_2|$) can be compared to a predetermined threshold value $t_{th}$. An alert signal can be generated if the threshold value $t_{th}$ is exceeded.

### Loop process

In some embodiments, the method comprises a cyclically series of operations. In other words, the method described at the beginning is reiterated N times, for example in a period of several hours. And the measurements and/or extracted data are stored to constitutes a history of events related to the degradation of the elements 11 during an operational period of the module 1 longer than that of a single turn-off period. Then, or in real-time, the extracted data at the current time can be compared to the extracted data before. If the comparison shows that there is an evolution, a degradation index of the module 1 can be incremented. Once such a degradation index achieves a predetermined value (a threshold), a warning signal is generated.

The degradation of the modules 1 can be observed during the entire lifetime even for the case where any mismatch is present on the $V_{eE}$ waveforms. Furthermore, the current degradation level of each element 11 can be identified (not only related from one to another). The following [Table 3] shows an example of four measures made in an interval of 1000 hours each and the voltages of the first peaks I are measured and saved in the table.

[Table 3]

| Measure 1 | Measure 2 | Measure 3 | Measure 4 | ... |
|---|---|---|---|---|
| El. 11.1: +3.65V<br>El. 11.2: -2.8V | El. 11.1: +2.69V<br>El. 11.2: -2.1V | El. 11.1: +1.73V<br>El. 11.2: -1.12V | El. 11.1: +2.48V<br>El. 11.2: -1.85V | ... |

Data extracted and stored in [Table 3] shows that:

- From Measure 2 compared to Measure 1, the element 11.2 has been degraded faster than element 11.1 → A degradation index of the element 11.2 can be increased
- From Measure 3 compared to Measure 2, the element 11.2 has been degraded faster than element 11.1 → A degradation index of the element 11.2 can be increased
- From Measure 4 compared to Measure 3, the element 11.1 has been degraded faster than element 11.2 → A degradation index of the element 11.1 can be increased.

In the example described here, the threshold value to trigger an alert/warning signal is previously set to correspond to a situation wherein fifth wire bonding are lift-off. The threshold value is obtained by testing prototypes. The definition of the threshold value can vary and can be adapted to the context by a person skilled in the art.

[Fig. 21] shows a schematic example of the evolution over the time of the voltage $V_{e1e2}$ between the two emitters of elements 11.1 and 11.2, and the corresponding degradation indexes.

**Conclusion**

The differential electrical, thermal and degradation of parallel power elements leads to current unbalance in steady state. This is due to the non-homogeneous electrical resistance, junction temperature creating a non-homogeneous current distribution. Monitoring this current unbalance is thus a differential electrical, thermal and damage sensitive parameter. However, it requires monitoring the individual power element currents at relatively high resolution which is technically complex and costly.

The methods based on monitoring the transient switching waveforms were generally considered expensive, inaccurate and non-robust due to the high frequency sensor requirements, the low sensitivity and the complex dependencies with operating conditions and design.

In order to achieve high current capabilities, a technique consists to parallel power elements (dies, converters or sub-set of elements for example). This solution is largely adopted given the flexibility and scalability of the current power electronics installations. Among the problematic that should be faced with the parallelisation of the power electronics installations, the current distribution caused by the nonuniform electrical-thermal-damage characteristics should be identified during the commissioning, usage and maintenance phases.

A problem addressed by the method above disclosed is the safe, accurate, and low-cost current distribution and degradation monitoring of the electro-thermal interconnections of individual power elements in parallel, and automatic generation of alert signals. By (at least) identifying the mismatches based on the sign and/or the amplitude of a sequence of peaks during the turn-off switching time using the $V_{eE}$ (voltage between kelvin and emitter) of the power elements, it is possible to address such a problem.

**Industrial Applicability**

The technical solutions presented here can be used to automatically trigger alert signals to implement corrective actions, such as repairs or functional adaptations to the power modules, or even targeted replacements.

This disclosure is not limited to the methods, modules and computer programs described here, which are only examples. The invention is defined by the independent claims.

**Reference Signs List**

- 1: System
- 11: power electronic element
- 2: conductive wire bond
- 101: electrical insulator layer
- 102: conductive layer
- 103: solder layer
- 104: semiconductor die
- 105: metallization layer
- 201: signal conditioning circuit
- 202: signal conditioning circuit
- 203: RS flip flop and inverter
- O: triggering peak
- I: first peak
- II: second peak
- III: third peak
- A: waveform
- B: waveform
- C: waveform.

## Claims

1. Method for detection of a mismatch between power electronic elements (11) electrically connected in parallel in a power electronic module (1), said method comprising:

   a. in response to the detection of a common turn-off of said elements (11), triggering a measuring period;
   b. during the measuring period, measuring a sequence of emitter voltages $V_{eE}$ between two emitter connections, at least one of them being specific to one element among said elements;
   c. extract data, from the measurements, said data including the signs and/or the amplitude of local extremums of said emitter voltages $V_{eE}$ during the measuring period;
   d. deduce from the extracted data, including said signs and/or amplitude of local extremums of said emitter voltages $V_{eE}$, at least an existence or an absence of a mismatch between said elements.

2. Method according to claim 1, wherein the extracted data include at least:

   - the signs of local extremums of a sequence of two emitter voltages $V_{eE1}$ and $V_{eE2}$ of two elements, or
   - the sign and the amplitude of local extremums of a sequence of emitter voltages $V_{eE}$ of one element;

   and, if a presence of a mismatch between said elements has been deduced, the method further comprising:
   e. deduce from the extracted data if an element of which the emitter voltages $V_{eE}$, or $V_{eE1}$ and $V_{eE2}$, have been measured is, or is not, the most degraded.

3. Method according to one of the preceding claims, wherein the extraction from the measurements is made by an analog and logical circuit, such that the use of an Analog to Digital Converter is made redundant.

4. Method according to one of the preceding claims, wherein the extracted data further includes amplitudes of local extremums of said emitter voltages $V_{eE}$ during the measuring period and, if a presence of a mismatch between said elements has been deduced, the method further comprising:
   f. deduce from the extracted data a quantification of said mismatch.

5. Method according to one of the preceding claims, wherein a differential emitter voltage $V_{ee}$ of a pair of elements (11.1, 11.2) is measured.

6. Method according to one of the preceding claims, implemented on a module (1) comprising at least three power electronic elements (11) electrically connected in parallel, wherein the measurements are made in a sequenced manner for each pair of elements (11) with a common monitoring circuit, a multiplexer being operationally interfaced between said monitoring circuit and said elements (11).

7. Method according to one of the preceding claims, further comprising:

   - imposing a supplementary external gate resistance during the measuring operation.

8. Method according to one of the preceding claims, wherein the deduction operation further comprises to identify a most degraded element (11) among at least two elements (11), and then the series of operations is reiterated at least one time, the at least one reiteration including to induce a delay d of the turn-off of at least one of the elements with respect to another element before triggering the measuring period.

9. Method according to one of the preceding claims, wherein the series of operations is reiterated at least one time such that the detection of a mismatch is implemented along the operational life of the module (1).

10. Method according to one of the preceding claims, further comprising:

    - generating an alert signal in function of the deduced information.

11. Power electronic module (1) comprising at least two power electronic elements (11) electrically connected in parallel and an analog and logical circuit arranged to implement the method according to one of claims 1 to 10.

12. Computer software comprising instructions to implement a method according to one of claims 1 to 10 when the software is executed by a processor.

**13.** Computer-readable non-transient recording medium on which a software is registered to implement a method according to one of claims 1 to 10 when the software is executed by a processor.

**Patentansprüche**

**1.** Verfahren zur Detektion einer Fehlanpassung zwischen Leistungselektronikelementen (11), welche in einem Leistungselektronikmodul (1) elektrisch parallel geschaltet sind, wobei das Verfahren umfasst:

a) in Reaktion auf die Detektion eines gemeinsamen Ausschaltens der Elemente (11), Auslösen einer Messperiode;
b) Während der Messperiode, Messen einer Sequenz von Emitter-Spannungen $V_{eE}$ zwischen zwei Emitterverbindungen, wobei wenigstens eine von ihnen spezifisch zu einem Element unter den Elementen ist;
c) Extrahieren von Daten, aus den Messungen, wobei die Daten die Vorzeichen und/oder die Amplitude von lokalen Extrema der Emitter-Spannungen $V_{eE}$ während der Messperiode umfassen;
d) Rückschließen aus den extrahierten Daten, welche die Vorzeichen und/oder Amplitude von lokalen Extrema der Emitter-Spannungen $V_{eE}$ umfassen, wenigstens eines Vorliegens oder einer Abwesenheit einer Fehlanpassung zwischen den Elementen.

**2.** Verfahren nach Anspruch 1, wobei die extrahierten Daten wenigstens umfassen:

- die Vorzeichen von lokalen Extrema einer Sequenz von zwei Emitter-Spannungen $V_{eE1}$ und $V_{eE2}$ von zwei Elementen, oder
- das Vorzeichen und die Aplitude von lokalen Extrema einer Sequenz von Emitter-Spannungen $V_{eE}$ eines Elements; und falls ein Vorliegen einer Fehlanpassung zwischen den Elementen rückgeschlossen worden ist, das Verfahren ferner umfasst:

e) Rückschließen aus den extrahierten Daten, ob ein Element, von welchem die Emitter-Spannungen $V_{eE}$, oder $V_{eE1}$ und $V_{eE2}$, gemessen worden sind, das am meisten verschlechterte ist oder nicht.

**3.** Verfahren nach einem der vorhergehenden Ansprüche, wobei die Extrahierung aus den Messungen durch eine analoge und logische Schaltung vorgenommen wird, so dass die Nutzung eines Analog-Digital-Wandlers redundant gemacht wird.

**4.** Verfahren nach einem der vorhergehenden Ansprüche, wobei die extrahierten Daten ferner Amplituden von lokalen Extrema der Emitter-Spannungen $V_{eE}$ während der Messperiode umfassen, und, falls auf eine Anwesenheit einer Fehlanpassung zwischen den Elementen rückgeschlossen worden ist, das Verfahren ferner umfasst:
f) Rückschließen einer Quantifizierung der Fehlanpassung aus den extrahierten Daten.

**5.** Verfahren nach einem der vorhergehenden Ansprüche, wobei eine differentielle Emitter-Spannung $V_{ee}$ eines Paars aus Elementen (11.1, 11.2) gemessen wird.

**6.** Verfahren nach einem der vorhergehenden Ansprüche, welches an einem Modul (1) implementiert wird, welches wenigstens drei Leistungselektronikelemente (11) umfasst, welche elektrisch parallel geschaltet sind, wobei die Messungen in einer sequenziellen Weise für jedes Paars aus Elementen (11) mit einer gemeinsamen Überwachungsschaltung vorgenommen werden, wobei ein Multiplexer zwischen der Überwachungsschaltung und den Elementen (11) operativ gekoppelt ist.

**7.** Verfahren nach einem der vorhergehenden Ansprüche, ferner umfassend:

- Anlegen eines zusätzlichen externen Gate-Widerstands während des Messvorgangs.

**8.** Verfahren nach einem der vorhergehenden Ansprüche, wobei der Rückschlussvorgang ferner umfasst, ein am meisten verschlechtertes Element (11) unter wenigstens zwei Elementen (11) zu identifizieren und dann die Abfolge von Vorgängen wenigstens ein Mal wiederholt wird, wobei die wenigstens eine Wiederholung ein Induzieren einer Verzögerung d des Ausschaltens von wenigstens einem der Elemente in Bezug auf ein anderes Element vor dem Auslösen der Messperiode umfasst.

**9.** Verfahren nach einem der vorhergehenden Ansprüche, wobei die Abfolge von Vorgängen wenigstens ein Mal wiederholt wird, so dass die Detektion einer Fehlanpassung über die Betriebsdauer des Moduls (1) implementiert wird.

**10.** Verfahren nach einem der vorhergehenden Ansprüche, ferner umfassend:

- Generieren eines Alarmsignals in Abhängigkeit der rückgeschlossenen Informationen.

**11.** Leistungselektronikmodul (1), welches wenigstens zwei Leistungselektronikelemente (11), welche elektrisch parallel geschaltet sind, und eine analoge und logische Schaltung umfasst, welche angeordnet ist, um das Verfahren nach einem der Ansprüche 1 bis 10 zu implementieren.

**12.** Computersoftware, umfassend Anweisungen ein Verfahren nach einem der Ansprüche 1 bis 10 zu implementieren, wenn die Software durch einen Prozessor ausgeführt wird.

**13.** Computerlesbares nichtflüchtiges Speichermedium, auf welchem eine Software aufgezeichnet ist, um ein Verfahren nach einem der Ansprüche 1 bis 10 zu implementieren, wenn die Software durch einen Prozessor ausgeführt wird.

## Revendications

**1.** Procédé de détection d'une discordance entre des éléments électroniques de puissance (11) reliés électriquement en parallèle dans un module électronique de puissance (1), ledit procédé comprenant :

a. en réponse à la détection d'une mise hors tension commune desdits éléments (11), le déclenchement d'une période de mesure :
b. pendant la période de mesure, la mesure d'une séquence de tensions d'émetteur $V_{eE}$ entre deux liaisons d'émetteur, au moins l'une d'entre elles étant spécifique à un élément parmi lesdits éléments ;
c. l'extraction de données, à partir des mesures, lesdites données comportant les signes et/ou l'amplitude d'extrêmes locaux desdites tensions d'émetteur $V_{eE}$ pendant la période de mesure ;
d. la déduction, à partir des données extraites, y compris lesdits signes et/ou ladite amplitude d'extrêmes locaux desdites tensions d'émetteur $V_{eE}$, d'au moins une existence ou une absence de discordance entre lesdits éléments.

**2.** Procédé selon la revendication 1, dans lequel les données extraites comportent au moins :

- les signes d'extrêmes locaux d'une séquence de deux tensions d'émetteur $V_{eE1}$ et $V_{eE2}$ de deux éléments, ou
- le signe et l'amplitude d'extrêmes locaux d'une séquence de tensions d'émetteur $V_{eE}$ d'un élément ;

et, si une présence d'une discordance entre lesdits éléments a été déduite, le procédé comprenant en outre :
e. la déduction, à partir des données extraites, si un élément, dont les tensions d'émetteur $V_{eE}$, ou $V_{eE1}$ et $V_{eE2}$, ont été mesurées, est ou n'est pas le plus dégradé.

**3.** Procédé selon l'une des revendications précédentes, dans lequel l'extraction à partir des mesures est réalisée par un circuit analogique et logique, de sorte que l'utilisation d'un convertisseur analogique-numérique soit rendue redondante.

**4.** Procédé selon l'une des revendications précédentes, dans lequel les données extraites comportent en outre des amplitudes d'extrêmes locaux desdites tensions d'émetteur $V_{eE}$ pendant la période de mesure et, si une présence d'une discordance entre lesdits éléments a été déduite, le procédé comprenant en outre :
f. la déduction, à partir des données extraites, d'une quantification de ladite discordance.

**5.** Procédé selon l'une des revendications précédentes, dans lequel une tension différentielle d'émetteur $V_{ee}$ d'une paire d'éléments (11.1, 11.2) est mesurée.

**6.** Procédé selon l'une des revendications précédentes, mis en œuvre sur un module (1) comprenant au moins trois éléments électroniques de puissance (11) reliés électriquement en parallèle, dans lequel les mesures sont réalisées de manière séquentielle pour chaque paire d'éléments (11) avec un circuit de surveillance commun, un multiplexeur étant opérationnellement interfacé entre ledit circuit de surveillance et lesdits éléments (11).

**7.** Procédé selon l'une des revendications précédentes, comprenant en outre :

- l'imposition d'une résistance de grille externe supplémentaire pendant l'opération de mesure.

**8.** Procédé selon l'une des revendications précédentes, dans lequel l'opération de déduction comprend en outre l'identification d'un élément (11) le plus dégradé parmi au moins deux éléments (11), puis la série d'opérations est réitérée au moins une fois, l'au moins une réitération comportant l'induction d'un retard d de la mise hors tension d'au moins un des éléments par rapport à un autre élément avant le déclenchement de la période de mesure.

**9.** Procédé selon l'une des revendications précédentes, dans lequel la série d'opérations est réitérée au moins une fois de sorte que la détection d'une discordance soit mise en œuvre tout au long de la durée de vie opérationnelle du module (1).

**10.** Procédé selon l'une des revendications précédentes, comprenant en outre :

- la génération d'un signal d'alerte en fonction des informations déduites.

**11.** Module électronique de puissance (1) comprenant au moins deux éléments électroniques de puissance (11) reliés électriquement en parallèle et un circuit analogique et logique agencé pour mettre en œuvre le procédé selon l'une des revendications 1 à 10.

**12.** Logiciel d'ordinateur comprenant des instructions pour mettre en œuvre un procédé selon l'une des revendications 1 à 10 lorsque le logiciel est exécuté par un processeur.

**13.** Support d'enregistrement non transitoire lisible par ordinateur sur lequel un logiciel est enregistré pour mettre en œuvre un procédé selon l'une des revendications 1 à 10 lorsque le logiciel est exécuté par un processeur.

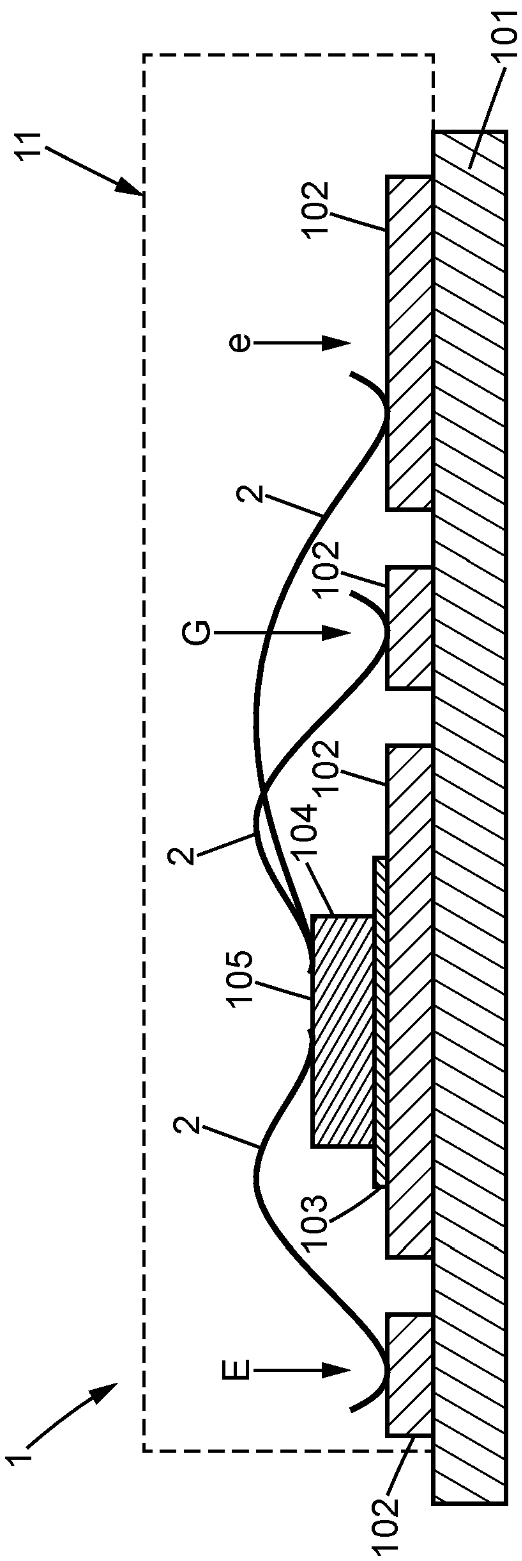


FIG. 1

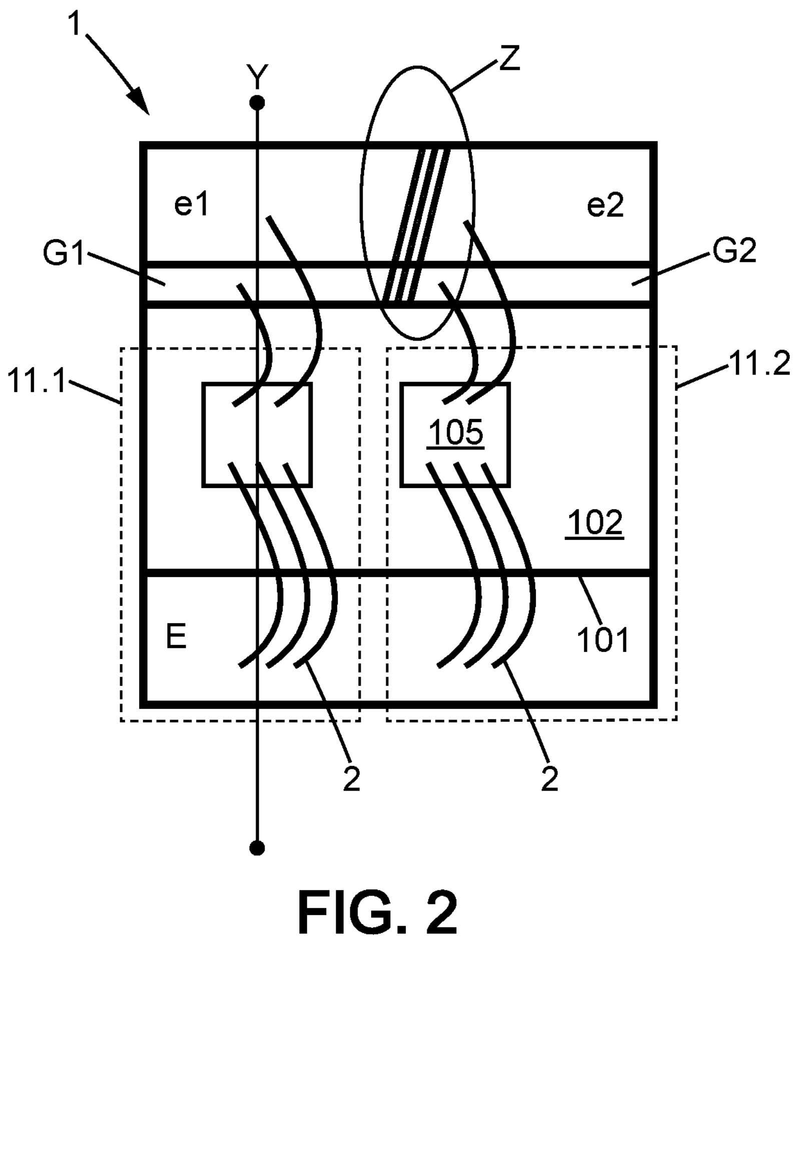


FIG. 2

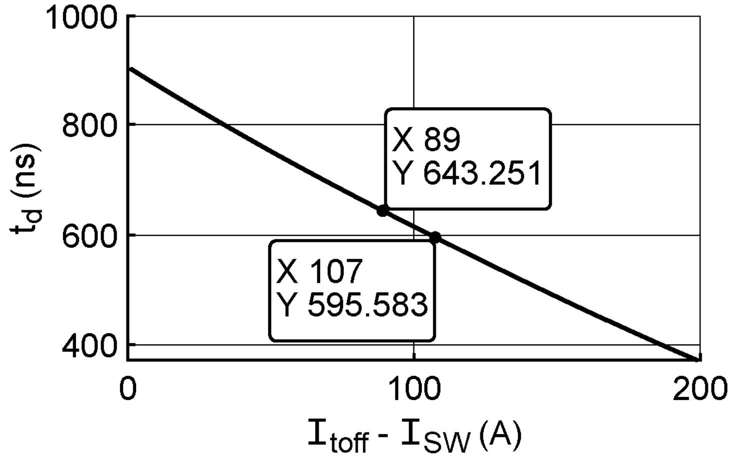


FIG. 3

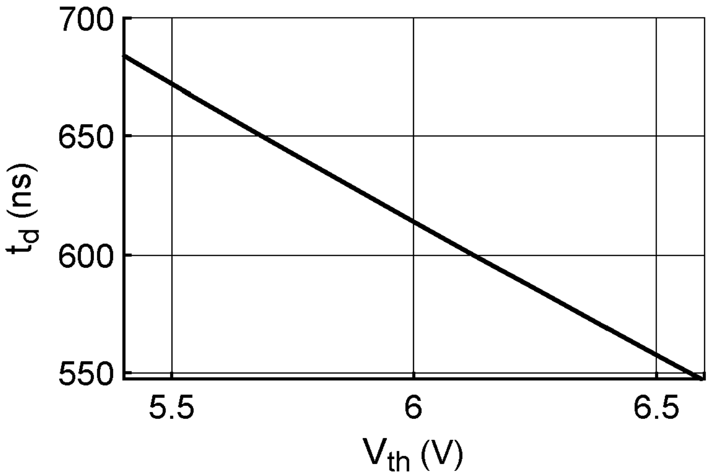


FIG. 4

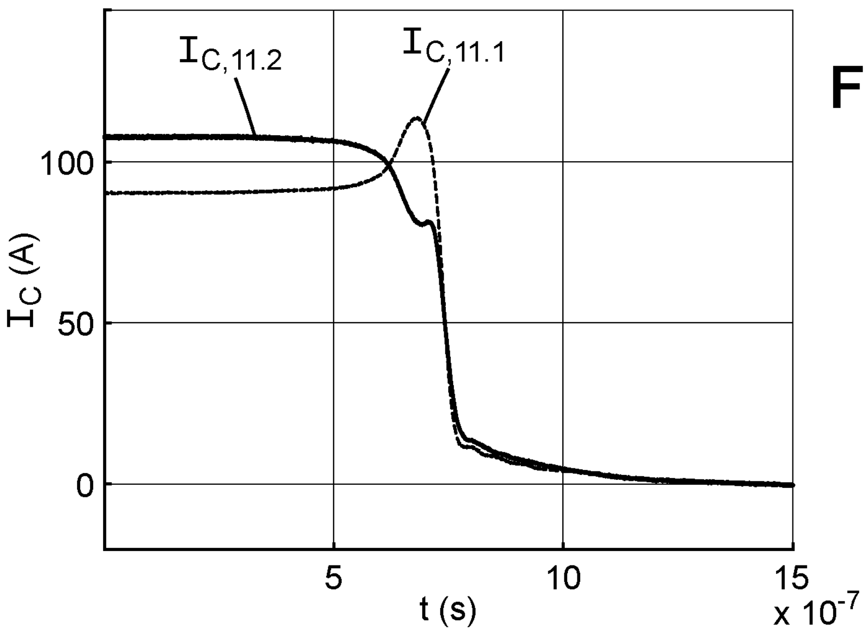


FIG. 5

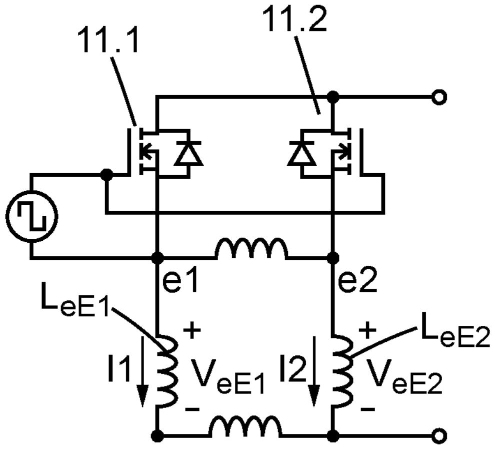


FIG. 6

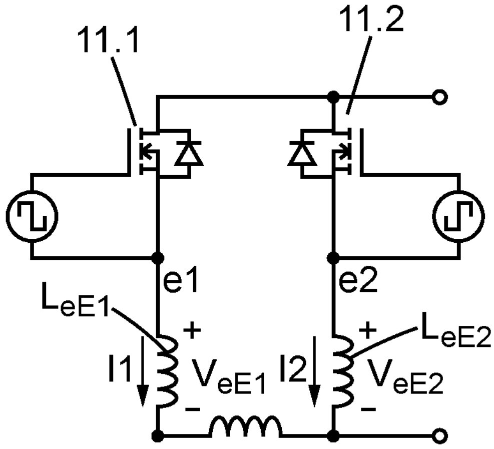


FIG. 7

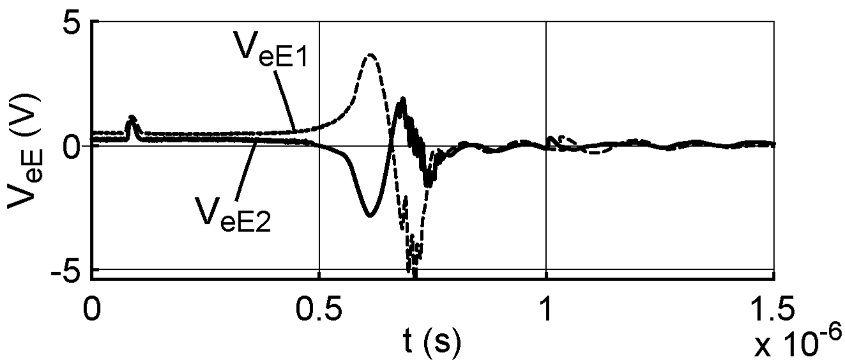


FIG. 8

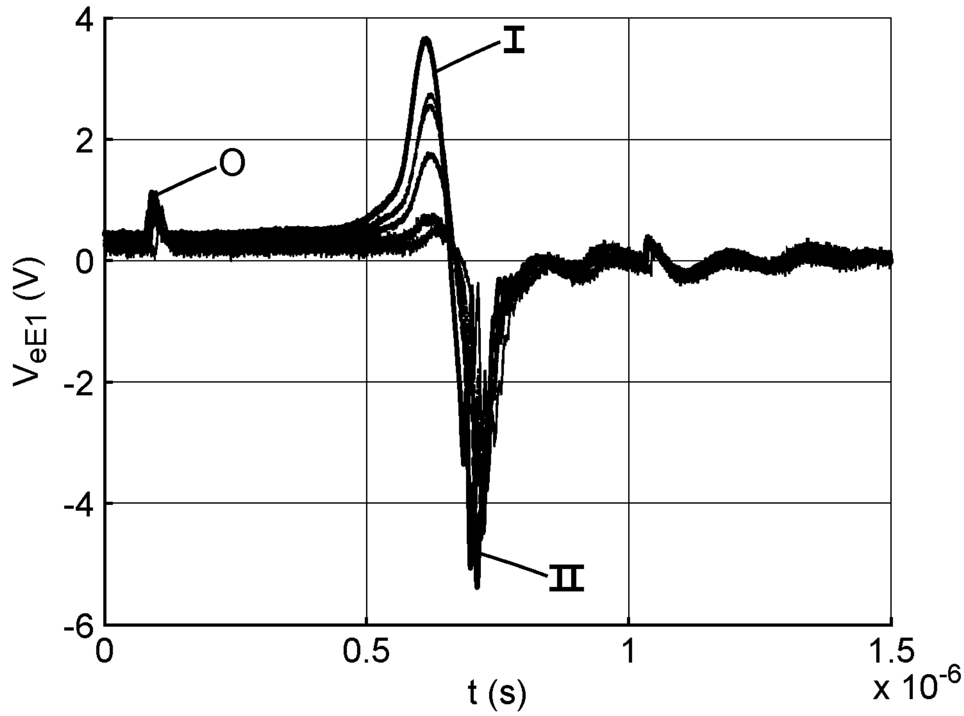
4
2
0
-2
-4
-6
0
0.5
1
1.5
x 10-6
t (s)
VeE1 (V)
O
I
II

FIG. 9

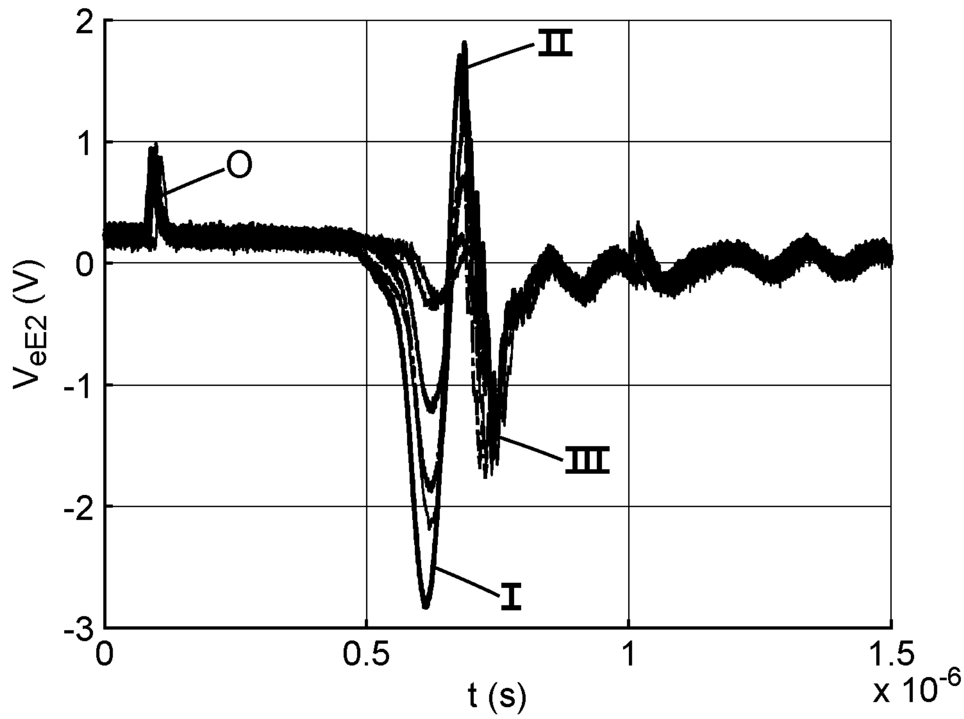
2
1
0
-1
-2
-3
0
0.5
1
1.5
x 10-6
t (s)
VeE2 (V)
O
II
III
I

FIG. 10

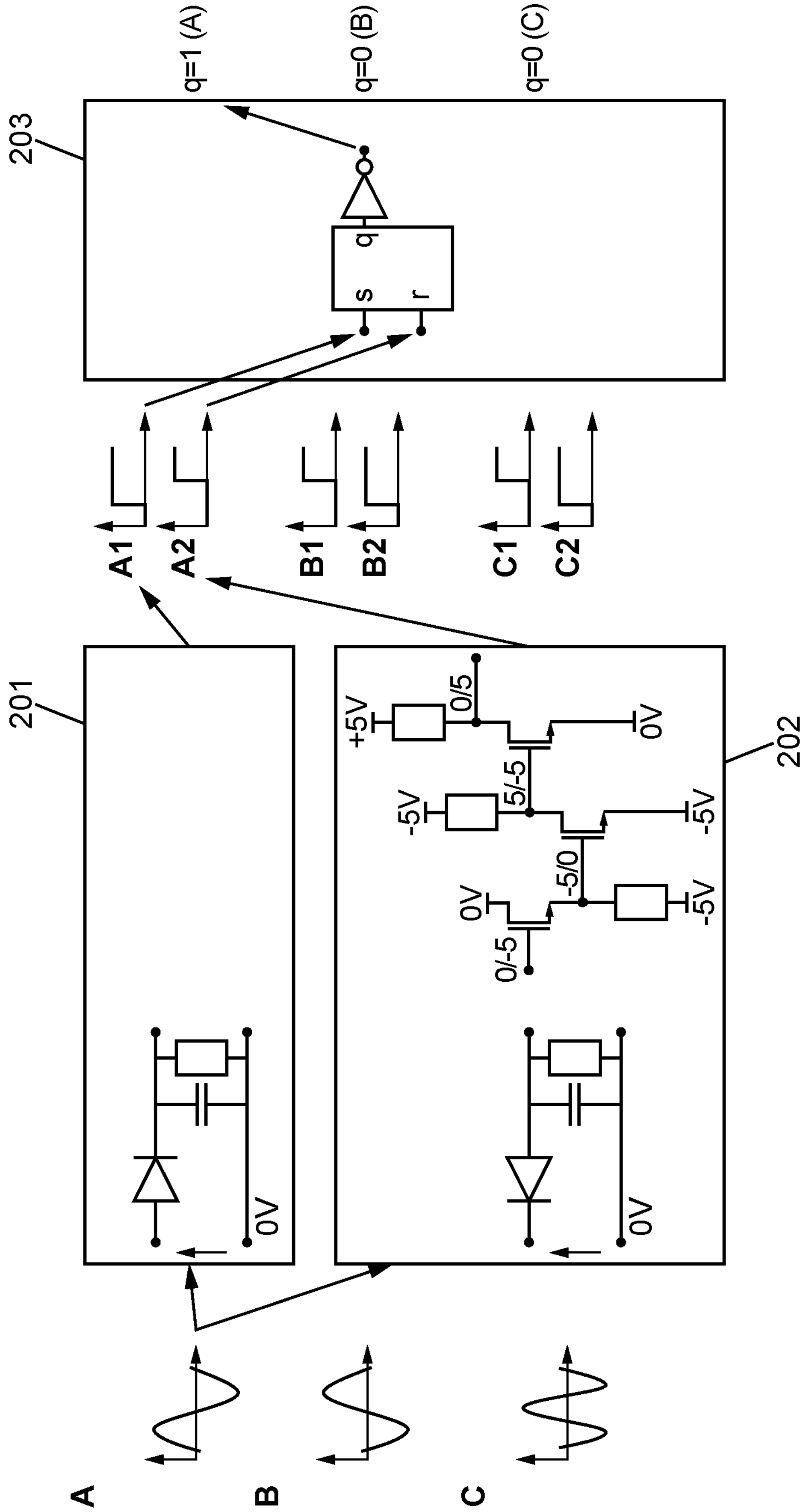
203
q=1 (A)
q=0 (B)
q=0 (C)
s
r
q
A1
A2
B1
B2
C1
C2
201
202
+5V
0/5
0V
-5V
5/-5
-5/0
0/-5
0V
A
B
C

FIG. 11

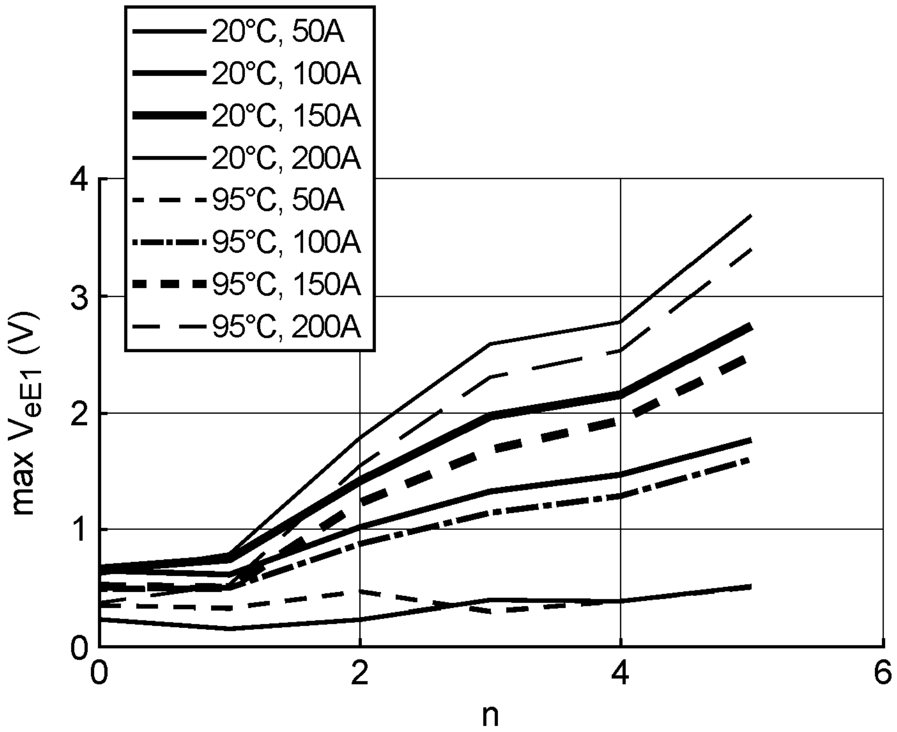
20°C, 50A
20°C, 100A
20°C, 150A
20°C, 200A
95°C, 50A
95°C, 100A
95°C, 150A
95°C, 200A
max $V_{eE1}$ (V)
n
0
1
2
3
4
0
2
4
6

FIG. 12

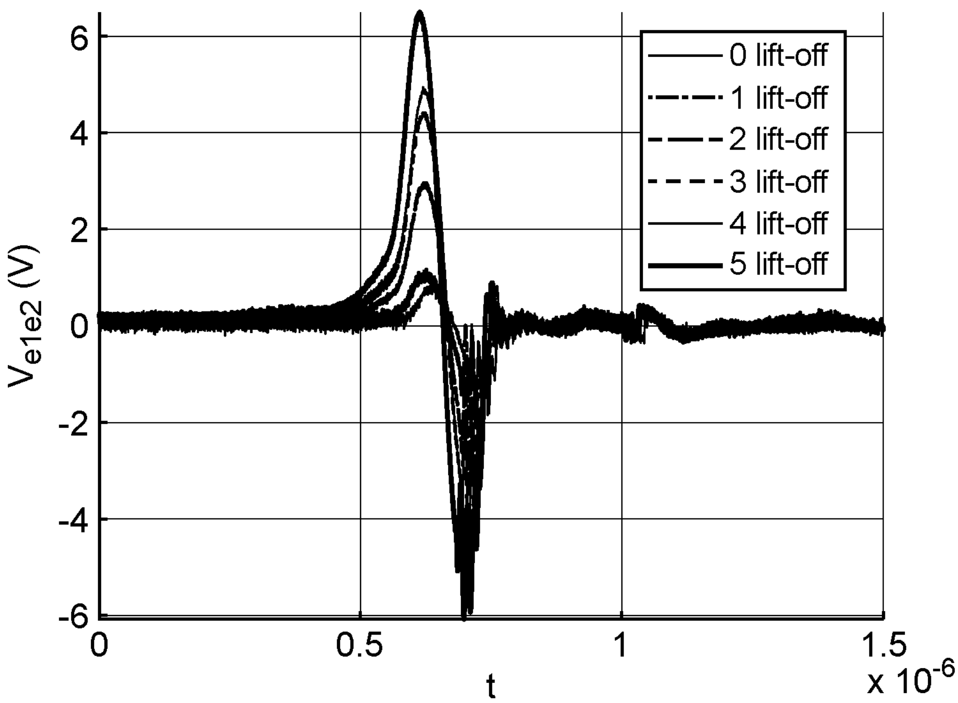
0 lift-off
1 lift-off
2 lift-off
3 lift-off
4 lift-off
5 lift-off
$V_{e1e2}$ (V)
t
x $10^{-6}$
6
4
2
0
-2
-4
-6
0
0.5
1
1.5

FIG. 13

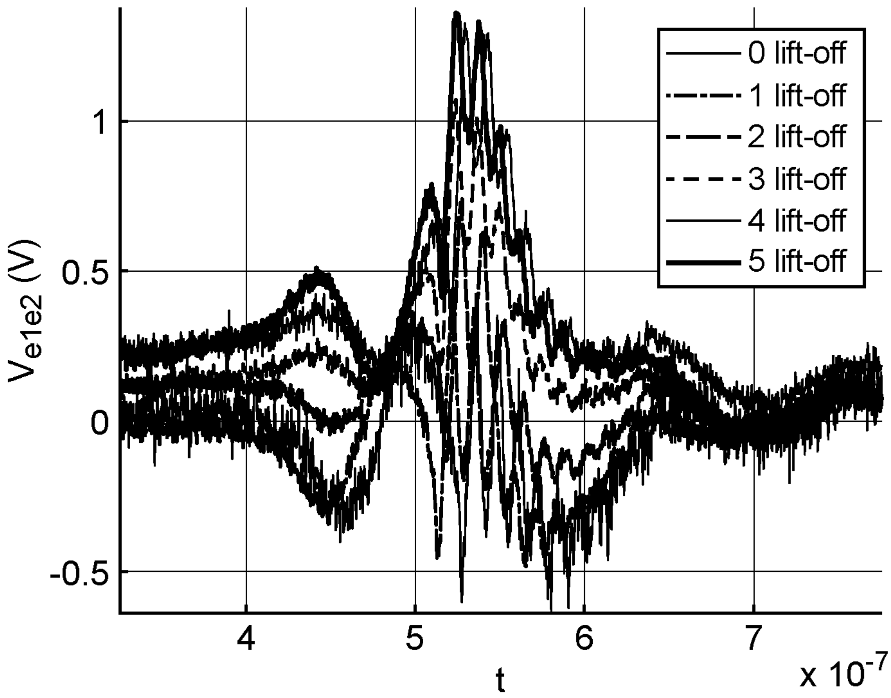
0 lift-off
1 lift-off
2 lift-off
3 lift-off
4 lift-off
5 lift-off
1
0.5
0
-0.5
Ve1e2 (V)
4
5
6
7
t
x 10-7

FIG. 14

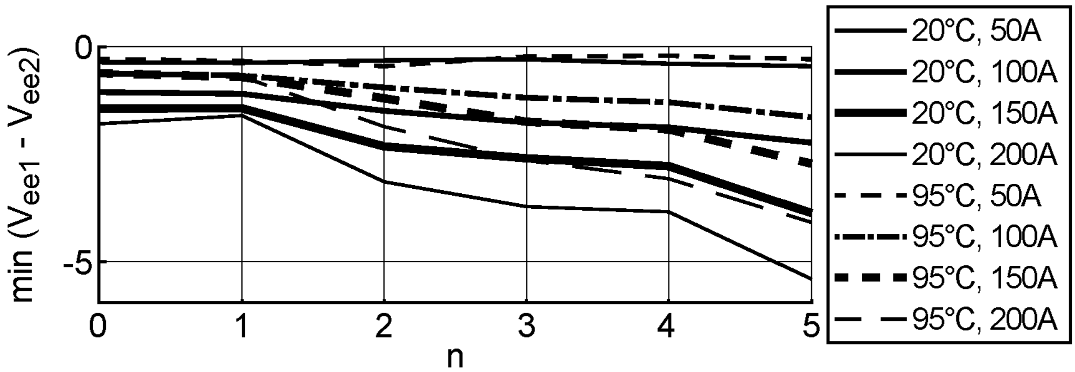


FIG. 15

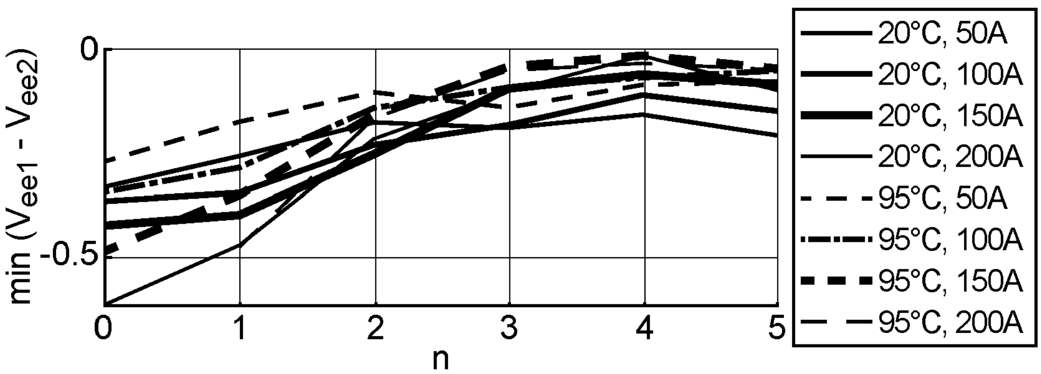


FIG. 16

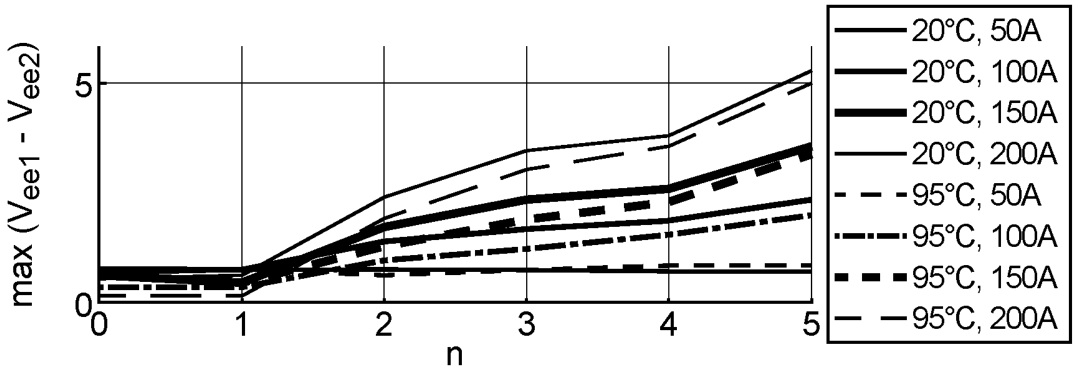


FIG. 17

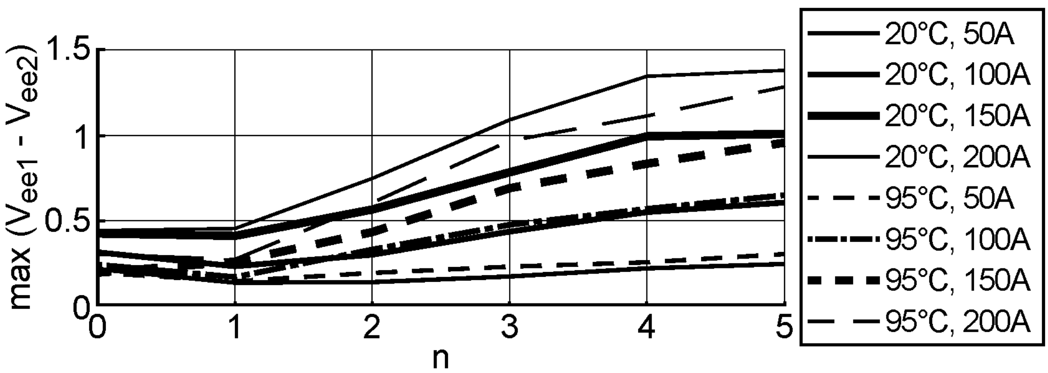


FIG. 18

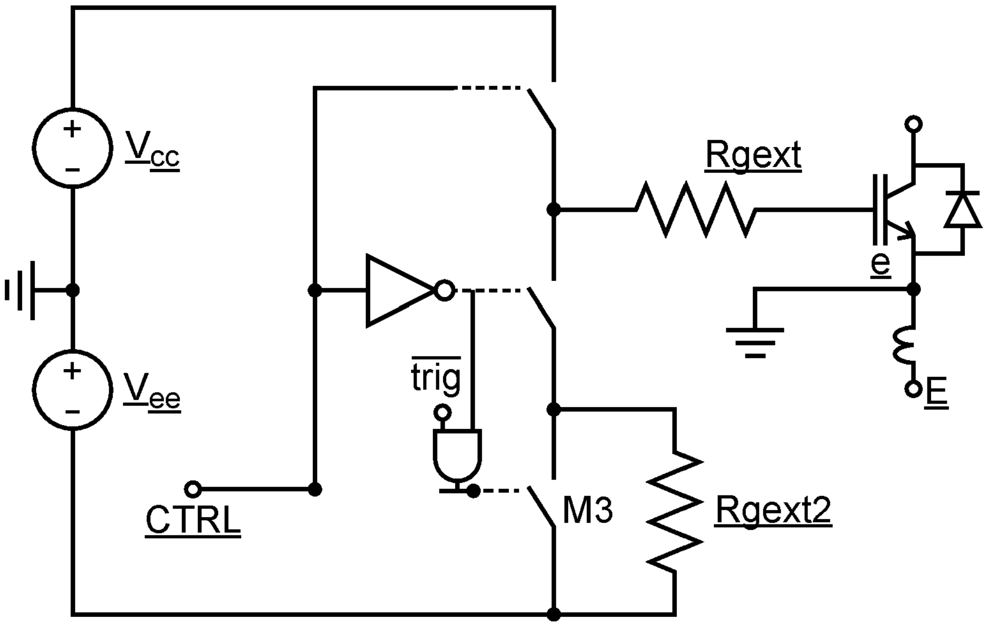


FIG. 19

FIG. 20

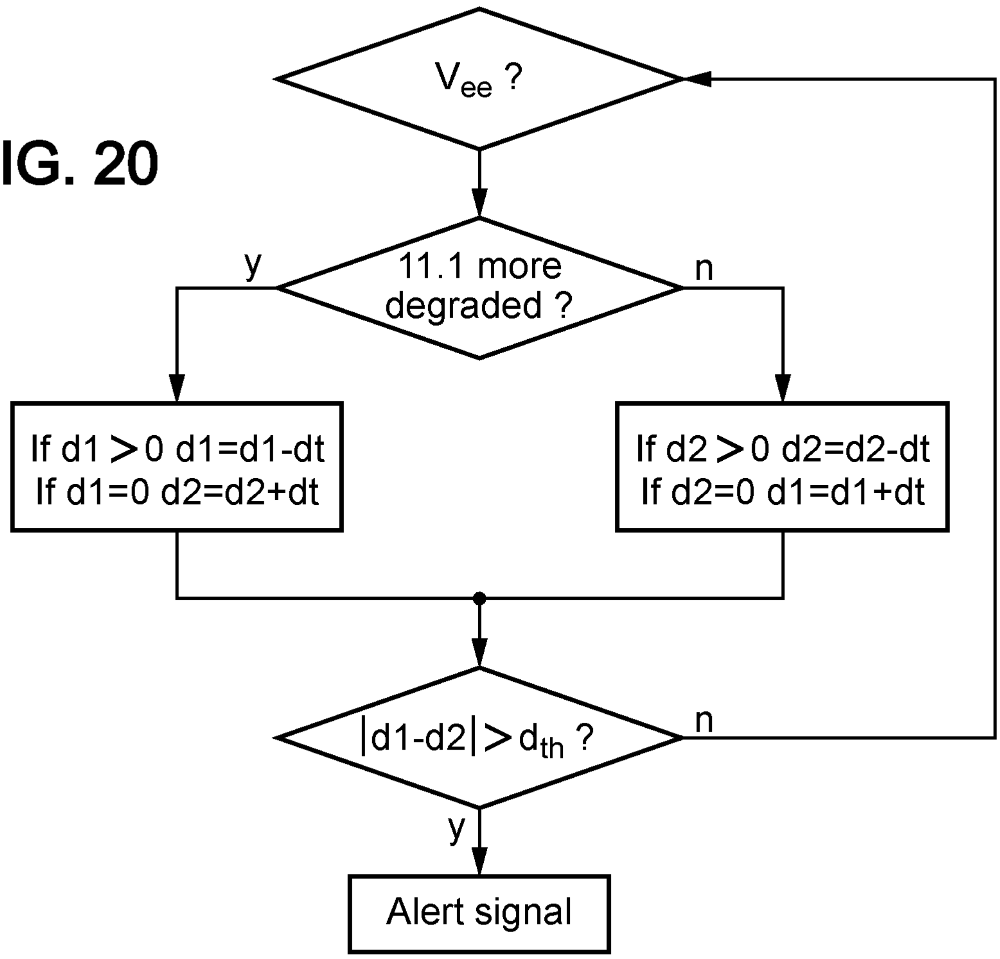
$V_{ee}$ ?
11.1 more degraded ?
y
n
If d1 > 0 d1=d1-dt
If d1=0 d2=d2+dt
If d2 > 0 d2=d2-dt
If d2=0 d1=d1+dt
|d1-d2| > $d_{th}$ ?
n
y
Alert signal

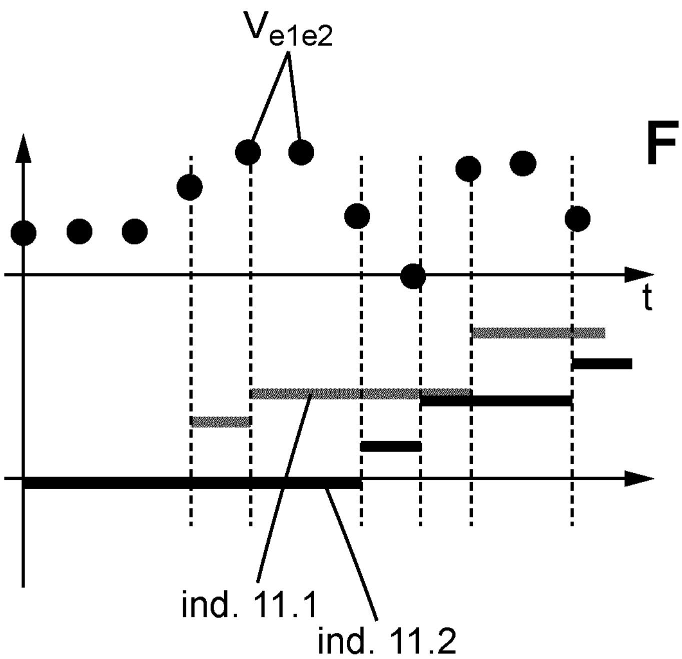
$V_{e1e2}$
t
ind. 11.1
ind. 11.2

FIG. 21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3121612 A